(19)

**Europäisches Patentamt**

**European Patent Office**

**Office européen des brevets**

(11) **EP 4 185 962 B1**

(12) **EUROPEAN PATENT SPECIFICATION**

(45) Date of publication and mention
of the grant of the patent:
**10.06.2026 Bulletin 2026/24**

(21) Application number: **20761237.5**

(22) Date of filing: **24.08.2020**

(51) International Patent Classification (IPC):
**G06F 11/3668** *(2025.01)*    **G06F 11/3698** *(2025.01)*

(52) Cooperative Patent Classification (CPC):
**G06F 11/3698; G06F 11/3684**

(86) International application number:
**PCT/EP2020/073655**

(87) International publication number:
**WO 2022/042822 (03.03.2022 Gazette 2022/09)**

(54) **VALIDATING A SOFTWARE-DRIVEN SYSTEM BASED ON REAL-WORLD SCENARIOS**

VALIDIERUNG EINES SOFTWAREGESTEUERTEN SYSTEMS AUF DER BASIS VON SZENARIEN DER REALEN WELT

VALIDATION D'UN SYSTÈME PILOTÉ PAR LOGICIEL D'APRÈS DES SCÉNARIOS DU MONDE RÉEL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.05.2023 Bulletin 2023/22**

(73) Proprietor: **Siemens Industry Software NV**
**3001 Leuven (BE)**

(72) Inventors:
• **RAMANATH, Vinay**
**Bengaluru, Karnataka 560070 (IN)**
• **SURESH, Suhas Karkada**
**Udupi District, Karnataka 576221 (IN)**

• **WORM, Matthieu**
**3000 Leuven (BE)**
• **D'IPPOLITO, Roberto**
**3001 Heverlee (BE)**

(74) Representative: **Isarpatent**
**Patent- und Rechtsanwälte Barth**
**Charles Hassa Peckmann & Partner mbB**
**Friedrichstrasse 31**
**80801 München (DE)**

(56) References cited:
**WO-A1-2019/234726    US-A1- 2017 168 809**
**US-B1- 9 811 074**

EP 4 185 962 B1

# EP 4 185 962 B1

**Description**

The present invention relates to a field of validation of a software-driven system, and more particularly relates to an apparatus and method for validating a software-driven system based on real-world scenarios.

Manufacturing companies typically perform numerous tests on their products before releasing them into the market. Such tests are performed in order to validate specifications of the products against predefined standards or regulatory compliances. The specifications may correspond to functional or non-functional aspects of a product. If the product passes all prescribed tests for validation, it is assumed that the product is ready for the market. Otherwise, the manufacturing company may redesign the product so as to ensure that the specifications meet the predefined standards or regulatory compliances.

However, testing of complex systems such as components of autonomous systems that operate in diverse environments pose several challenges. Testing of the complex systems may be cumbersome as behaviour of such autonomous systems is nondeterministic and is based on a context of operation. Also, since complex systems are not always under human control or supervision, it is crucial to ensure safe behaviour of such systems through Verification & Validation (V&V) methods.

US 9 811 074 B1 and WO 2019/234726 A1 specify validating an autonomous vehicle or robot based on real-world scenarios. Test scenarios for the vehicle are matched to "real-world scenarios" with different parameters". These "real-world scenarios" are then employed for identifying, based on a trained machine learning model, which scenarios to use for testing the vehicle in a simulation model (digital twin) to evaluate and to validate the behaviour of the vehicle in the real-world scenario.

Complex systems are typically tested through simulations of real-world scenarios. Such testings typically involve many experimental combinations. Each experimental combination may correspond to different settings of variable parameters associated with an environment of the complex system. However, some of the experimental combinations may be infeasible or impossible in real-world scenarios. Further, as simulations involved in the testings are computationally expensive, the infeasible scenarios add to the computational complexity.

In light of the above, there exists a need for a method and apparatus for validating a software-driven system based on feasible real-world scenarios.

Therefore, it is an object of the present invention to provide an apparatus and method for validating a software-driven system based on feasible real-world secenarios.

The invention is specified by the independent claims. Further preferred embodiments are defined by the dependent claims.

The object of the present invention is achieved by a method for validating a software-driven system based on real-world scenarios in a Computer-Aided Engineering environment as disclosed herein. Non-limiting examples of software-driven systems include machinery, embedded systems, vehicles, autonomous systems, automated guided vehicles and other complex systems that operate in diverse real-world conditions. In an embodiment, the software-driven system may have a nondeterministic behaviour in the real-world. For example, the behaviour of such software-driven systems may be governed by stimuli from the real-world as perceived by sensors associated with the software-driven system. Such stimuli are hereinafter collectively referred to as sensory inputs. In another example, the software-driven system may also operate based on inputs received from a human operator or another system through a communication interface.

The method comprises obtaining a plurality of test scenarios that correspond to testing of the software-driven system. In an embodiment of the present invention, the plurality of test scenarios are obtained in the form of variable parameter definitions from a source. The source may be an input device, a user device or a database. The variable parameters may include at least one of attributes and process parameters associated with the software-driven system. Attributes of the software-driven system include physical or functional characteristics resulting from a design of the software-driven system. Process parameters correspond to environmental factors associated with software-driven system. Based on the set of variable parameter definitions, a design space is generated. Here, the term 'design space' refers to a multidimensional combination and interaction of the variable parameters. The design space encompasses all possible combinations of the variable parameters. Each combination of the variable parameters in the design space corresponds to a test scenario or a design point. The design space may comprise both feasible test scenarios and infeasible test scenarios. The feasible test scenarios include test scenarios that are suitable for testing of the software-driven system. The infeasible test scenarios include test scenarios that are not suited for testing of the software-driven system. For example, the infeasible test scenarios may include scenarios that do not happen in real-world.

The method further comprises generating at least one real-world scenario associated with the software-driven system based on a set of the variable parameters. In an embodiment, generating the at least one real-world scenario comprises determining one or more constraints associated with the variable parameters. Further, the one or more constraints are applied to the design space in order to generate a pruned design space corresponding to the at least one real-world scenario.

Advantageously, the present invention facilitates pruning a design space for testing a software-driven system by applying one or more constraints to the design space. Consequently, unrealistic scenarios that do not occur in the real-world are eliminated from the test scenarios.

The method further comprises identifying one or more test scenarios which are suitable for testing the software-driven system based on the at least one real-world scenario from the plurality of test scenarios using a trained machine learning model. The identified one or more test scenarios are the feasible test scenarios that are to be used for testing of the software-driven system. The trained machine learning model may be any trained function that mimics cognitive functions that humans associate with other human minds. In particular, by training based on a training dataset the trained function is able to adapt to new circumstances and to detect and extrapolate patterns. In general, parameters of a trained function are adapted by means of training. In particular, supervised training, semi-supervised training, unsupervised training, reinforcement learning and/or active learning can be used. Furthermore, feature learning can be used. In particular, the parameters of the trained functions can be adapted iteratively by several steps of training. The trained machine learning model samples the pruned design space to generate the feasible test scenarios for testing of the software-driven system.

Advantageously, the present invention faciliates generating any number of test scenarios suitable for testing of the software-driven system through iterative sampling of the design space, while completely eliminating unrealistic test scenarios.

The method further comprises generating a simulated environment representing the at least one real-world scenario in which the software-driven system is to be tested, in the Computer-Aided Engineering environment. The simulated environment comprises simulated agents corresponding to agents in the real-world scenario and is generated using a simulation tool in the Computer-Aided Engineering environment. The term 'agents' as used herein may indicate objects in a physical environment associated with the software driven system. For example, if the software-driven system is an autonomous vehicle, the agents may include buildings, roads, trees, pedestrians, other vehicles and so on. The simulated agents may be, for example, physics-based models associated with the agents that are used to simulate sensory inputs to the software-driven system. The simulated agents may be static or dynamic in nature. In an embodiment, generating the simulated environment comprises configuring the simulated agents to represent the real-world conditions in which the software-driven system is expected to operate.

The method further comprises evaluating a behaviour of the software-driven system by applying the identified test scenarios on a model of the software-driven system in the simulated environment. In an embodiment, the method further comprises generating the model of the software-driven system in the Computer-Aided Engineering environment. The model may be, for example, an analytical model of the software-driven system in machine-executable form. In an embodiment, evaluating the behaviour of the software-driven system comprises generating a simulation instance based on the identified one or more test scenarios. The term 'simulation instance' as used herein may refer to a thread of simulation independent of all other threads during execution, that represents a state of the simulated environment. Further, the simulation results are analysed to determine the behaviour of the software-driven system in the one or more test scenarios.

Advantageously, the present invention faciliates testing of the software-driven system in a simulated environment that mimics real-world conditions. As a result, the behaviour of the software-driven system in the simulated environment corresponds an actual behaviour of the software-driven system in real-world conditions.

The method further comprises validating the behaviour of the software-driven system in the real-world scenario based on outcome of the evaluation. In an embodiment, validating the behaviour of the software-driven system comprises determining whether the behaviour of the software-driven system in the real-world scenario meets an expected standard.

Advantageously, the present invention faciliates validation of a software-driven system using only test scenarios corresponding to real-world scenarios. As a result, the present invention does not require human efforts in eliminating unrealistic test scenarios from the plurality of test scenarios as opposed to existing art.

The method further comprises generating a notification indicating the outcome of the validation on a Graphical User Interface. The notification may indicate whether the validation of the software-driven system is successful or not. If the validation is not successful, the notification may also indicate the test scenarios during which the behaviour of the software-driven system did not meet the expected standard.

Advantageously, the present invention faciliates faster and more efficient validation of software-driven systems compared to existing art due to less human intervention in the identification of test scenarios that are feasible.

In an embodiment, an apparatus for validating a software-driven system based on real-world scenarios is disclosed. The apparatus comprises a processor and a memory unit communicatively coupled to the one or more processing units. The memory unit comprises a testing module stored in the form of machine-readable instructions executable by the one or more processing units. The testing module is configured to perform method steps according to the method described above, upon execution. The execution of the testing module may also be performed using co-processors such as Graphical Processing Unit (GPU), Field Programmable Gate Array (FPGA) or Neural Processing/-Compute Engines. In addition, the memory unit may also include a database.

In one embodiment, the apparatus is a cloud computing system having a cloud computing based platform configured to provide a cloud service for validation of software-driven systems based on real-world scenarios. As used herein, "cloud computing" refers to a processing environment comprising configurable computing physical and logical resources, for example, networks, servers, storage, applications, services, etc., and data distributed over the network, for example, the internet. The cloud computing platform may be implemented as a service for management of medical imaging devices. In other words, the cloud computing system provides on-demand network access to a shared pool of the configurable computing physical and logical resources. The network is, for example, a wired network, a wireless network, a communication network, or a network formed from any combination of these networks.

The invention relates in one aspect to a computer-readable medium, on which program code sections of a computer program are saved, the program code sections being loadable into and/or executable in a data-processing system to make the data-processing system execute the method according to an aspect of the invention when the program code sections are executed in the data-processing system.

The realization of the invention by a computer program product and/or a computer-readable medium has the advantage that already existing testing systems can be easily adopted by software updates in order to work as proposed by the present invention.

The computer program product can be, for example, a computer program or comprise another element apart from the computer program. This other element can be hardware, for example a memory device, on which the computer program is stored, a hardware key for using the computer program and the like, and/or software, for example a documentation or a software key for using the computer program.

The above-mentioned attributes, features, and advantages of this invention and the manner of achieving them, will become more apparent and understandable (clear) with the following description of embodiments of the invention in conjunction with the corresponding drawings. The illustrated embodiments are intended to illustrate, but not limit the invention.

The present invention is further described hereinafter with reference to illustrated embodiments shown in the accompanying drawings, in which:

FIG 1A    illustrates a block diagram of an environment of an apparatus for validating a software-driven system based on feasible real-world scenarios, in accordance with an embodiment of the present invention;

FIG 1B    illustrates a block diagram of the apparatus for validating the software-driven system based on feasible real-world scenarios, in accordance with an embodiment of the present invention;

FIG 2    is a flowchart depicting a method 200 for validating a software-driven system based on feasible real-world scenarios, in accordance with an embodiment of the present invention;

FIG 3    is a flowchart depicting an exemplary method of obtaining a plurality of test scenarios for testing of an autonomous vehicle, in accordance with an embodiment of the present invention;

FIG 4    is a flowchart depicting an exemplary method of generating real-world scenarios associated with the autonomous vehicle based on the set of variable parameters, in accordance with an embodiment of the present invention;

FIG 5    illustrates a Graphical User Interface showing a two-dimensional view of the design space in which constraints associated with testing of the autonomous vehicle in real-world are applied, in accordance with an embodiment of the present disclosure;

FIG 6    is a flowchart depicting an exemplary method of identifying test scenarios suitable for testing the autonomous vehicle based on the real-world scenarios using a trained machine learning model, in accordance with an embodiment of the present invention;

FIG 7    is a flowchart depicting an exemplary method of generating test scenarios suitable for testing of the autonomous vehicle based on an optimization criterion, in accordance with an embodiment of the present invention;

FIG 8    is a flowchart depicting an exemplary method for determining test scenarios that are suitable for testing of the autonomous vehicle, in accordance with another embodiment of the present invention;

FIG 9    is a flowchart depicting an exemplary method for identifying test scenarios suitable for testing the autonomous vehicle, in accordance with yet another embodiment of the present invention; and

FIG 10    is a flowchart depicting an exemplary method for evaluating the behaviour of the autonomous vehicle, in accordance with an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

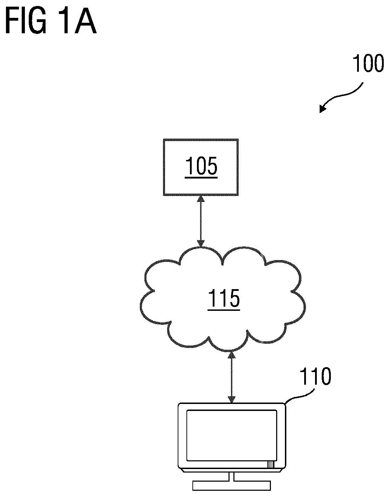

FIG 1A illustrates a block diagram of an environment 100 of an apparatus 105 for validating a software-driven system (not shown) based on real-world scenarios, in accordance with an embodiment of the present invention. More specifically, the environment 100 is a cloud-based system that facilitates Computer-Aided Engineering. The apparatus 105 is communicatively coupled to one or more user devices 110 over a network 115. The user device 110 may be for example, a human-machine interface that enables a testing personnel to interact with the apparatus 105.

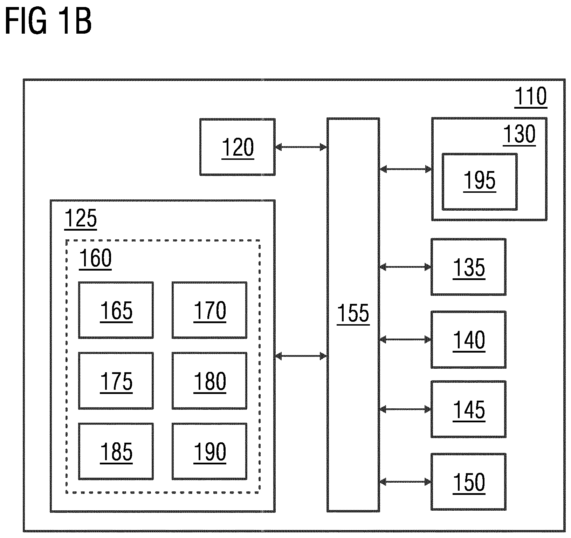

The apparatus 105 comprises a processing unit 120, a memory 125, a storage unit 130, a communication unit 135, a network interface 140, an input unit 145, an output unit 150, a standard interface or bus 155, as shown in FIG 1B. The apparatus 105 can be a (personal) computer, a workstation, a virtual machine running on host hardware, a microcontroller, or an integrated circuit. As an alternative, the apparatus 105 can be a real or a virtual group of computers (the technical term for a real group of computers is "cluster", the technical term for a virtual group of computers is "cloud"). The term 'processing unit', as used herein, means any type of computational circuit, such as, but not limited to, a microprocessor, a microcontroller, a complex instruction set computing microprocessor, a reduced instruction set computing microprocessor, a very long instruction word microprocessor, an explicitly parallel instruction computing microprocessor, a graphics processor, a digital signal processor, or any other type of processing circuit.

The processing unit 120 may also include embedded controllers, such as generic or programmable logic devices or arrays, application specific integrated circuits, single-chip computers, and the like. In general, the processing unit 120 may comprise hardware elements and software elements. The processing unit 120 can be configured for multithreading, i.e. the processing unit 120 may host different calculation processes at the same time, executing the either in parallel or switching between active and passive calculation processes.

The memory 125 may include one or more of a volatile memory and a non-volatile memory. The memory 125 may be coupled for communication with the processing unit 120. The processing unit 120 may execute instructions and/or code stored in the memory 125. A variety of computer-readable storage media may be stored in and accessed from the memory 125. The memory 125 may include any suitable elements for storing data and machine-readable instructions, such as read only memory, random access memory, erasable programmable read only memory, electrically erasable programmable read only memory, hard drive, removable media drive for handling compact disks, digital video disks, diskettes, magnetic tape cartridges, memory cards, and the like. The memory 125 comprises a testing module 160 that may be stored in the memory 125 in the form of machine-readable instructions and executable by the processing unit 120. These machine-readable instructions when executed by the processing unit 120 causes the processing unit 120 to perform validation of software-driven systems based on real-world scenarios. The testing module 160 comprises a preprocessing module 165, a scenario identification module 170, a test case generation module 175, an evaluation module 180, a validation module 185 and a report generation module 190.

The preprocessing module 165 is configured to obtain a plurality of test scenarios that correspond to testing of the software-driven system. In the present embodiment, the plurality of test scenarios are obtained from the user device 110, in the form of variable parameter definitions. Further, the preprocessing module 165 generates a design space based on the variable parameter definitions.

The scenario identification module 170 is configured to generate at least one real-world scenario associated with the software-driven system based on a set of variable parameters. The test case generation module 175 is configured to identify one or more test scenarios, from the plurality of test scenarios, which are suitable for testing the software-driven system based on the at least one real-world scenario using a trained machine learning model.

The evaluation module 180 generates a simulated environment representing the real-world scenario in which the software-driven system is to be tested. The evaluation module 180 is further configured to evaluate a behaviour of the software-driven system by applying the identified test scenarios on a model of the software-driven system in the simulated environment. The validation module 185 is configured to validate the behaviour of the software-driven system in the real-world scenario based on outcome of the evaluation. The report generation module 190 is configured to generate a notification indicating the outcome of the validation on a Graphical User Interface.

The storage unit 130 comprises a non-volatile memory which stores a database 195 comprising default values for variable parameter definitions and constraints. The input unit 145 may include input means such as keypad, touch-sensitive display, camera, etc. capable of receiving input signal. The bus 155 acts as interconnect between the processing unit 120, the memory 125, the storage unit 130, and the network interface 140.

The communication unit 135 enables the apparatus 105 to communicate with the one or more user devices 110.

The communication unit 135 may support different standard communication protocols such as Transport Control Protocol/Internet Protocol (TCP/IP), Profinet, Profibus, Bluetooth and Internet Protocol Version (IPv). The network interface 140 enables the apparatus 105 to communicate with the user device 110 over the network 115.

The apparatus 105 in accordance with an embodiment of the present invention includes an operating system employing a graphical user interface. The operating system permits multiple display windows to be presented in the graphical user interface simultaneously with each display window providing an interface to a different application or to a different instance of the same application. A cursor in the graphical user interface may be manipulated by a testing personnel through the pointing device. The position of the cursor may be changed and/or an event such as clicking a mouse button, generated to actuate a desired response.

One of various commercial operating systems, such as a version of Microsoft Windows™ may be employed if suitably modified. The operating system is modified or created in accordance with the present invention as described.

Those of ordinary skilled in the art will appreciate that the hardware depicted in FIGS 1A and 1B may vary for different implementations. For example, other peripheral devices such as an optical disk drive and the like, Local Area Network (LAN)/ Wide Area Network (WAN)/ Wireless (e.g., Wi-Fi) adapter, graphics adapter, disk controller, input/output (I/O) adapter, network connectivity devices also may be used in addition or in place of the hardware depicted. The depicted example is provided for the purpose of explanation only and is not meant to imply architectural limitations with respect to the present invention.

The present invention is not limited to a particular computer system platform, processing unit 120, operating system, or network. One or more aspects of the present invention may be distributed among one or more computer systems, for example, servers configured to provide one or more services to one or more client computers, or to perform a complete task in a distributed system. For example, one or more aspects of the present invention may be performed on a client-server system that comprises components distributed among one or more server systems that perform multiple functions according to various embodiments. These components comprise, for example, executable, intermediate, or interpreted code, which communicate over a network using a communication protocol. The present invention is not limited to be executable on any particular system or group of system, and is not limited to any particular distributed architecture, network, or communication protocol.

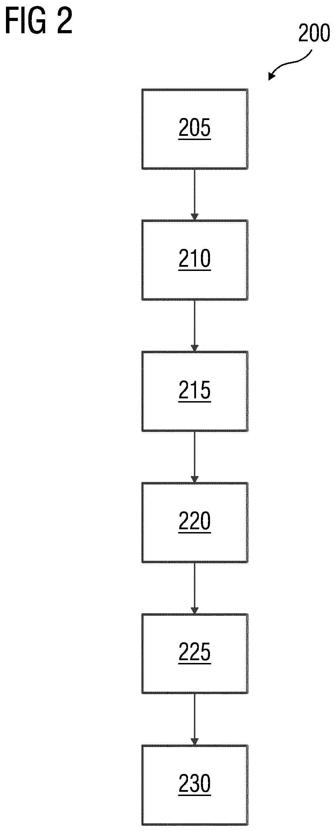

FIG 2 is a flowchart depicting a method 200 for validating a software-driven system based on real-world scenarios, in accordance with an embodiment of the present invention.

At step 205, a plurality of test scenarios that correspond to testing of the software-driven system are obtained from a source. In a preferred embodiment, a testing personnel inputs variable parameter definitions associated with each of the variables required for performing the test through a Graphical User Interface of the user device 110, which are further transmitted to the apparatus 110. For example, the variable parameter definition comprises an identifier and a range of values associated with each of the variable parameters. The variable parameters are chosen such that testing of the software-driven system based on various combinations of the variable parameters provide assurance of a quality of the software-driven system. In an example, the testing may be performed based on the variable parameters to check whether an operation of the software-driven system meets regulatory compliances. In another example, the testing may be performed to determine whether the software-driven system meets predetermined design specifications.

At step 210, at least one real-world scenario associated with the software-driven system is generated based on a set of variable parameters. In a preferred embodiment, the at least one real-world scenario is generated by firstly, determining one or more constraints associated with the variable parameters. Further, the one or more constraints are applied to the design space in order to generate a pruned design space corresponding to the at least one real-world scenario. In an example, the constraints may be explicitly defined by a testing personnel. In another example, the constraints are specified by the testing personnel graphically. In another example, where the constraints are unknown or not provided, the constraints may be determined using a machine learning model. More specifically, random test scenarios are generated by sampling the design space. Further, the testing personnel may accept or reject each of the test scenarios based on feasibility of the test scenario. Further, the machine learning model may determine the constraints based on the acceptance or rejection of the scenarios, for example, based on Convex-Hull approach.

At step 215, one or more test scenarios which are suitable for testing the software-driven system based on the at least one real-world scenario are identified from the plurality of test scenarios using a trained machine learning model. The trained machine learning model may comprise a neural network, a support vector machine, a decision tree and/or a Bayesian network, and/or the trained function can be based on k-means clustering, Qlearning, genetic algorithms and/or association rules. In particular, a neural network may be a deep neural network, a convolutional neural network or a convolutional deep neural network. Furthermore, a neural network can be an adversarial network, a deep adversarial network and/or a generative adversarial network. In an embodiment, samples are generated from the pruned design space using the trained machine learning model. The samples may be generated by feeding an input corresponding to the pruned design space to the trained machine learning model. In response to the input, the trained machine learning model generates the samples from the pruned design space. Further, the one or more test scenarios are identified based on the generated samples. For example, each sample may be a tuple comprising values of the variable parameters to be used in a specific test scenario.

In another embodiment, optimal samples are generated from the pruned design space based on at least one optimization criterion. In an embodiment, an optimization function based on an evolutionary algorithm may be used for generating the optimal samples. More specifically, random samples are generated from the pruned design space using a random sampling algorithm. Further, a cost criterion associated with the random samples is computed. Further, a predefined number of the random samples are selected based on the value of the cost criterion computed for each of the random samples. The selected random samples are further provided as inputs to the optimization function to generate optimal samples. Further, the one or more test scenarios are identified based on the generated optimal samples. Each of the optimal samples may be tuples comprising values of the variable parameters to be used in a specific test scenario.

At step 220, a simulated environment representing the real-world scenario in which the software-driven system is to be tested, is generated. In an embodiment, generating the simulated environment comprises configuring the simulated environment based on a type of testing corresponding to the one or more test scenarios. For example, in case of an autonomous robot, the simulated environment may be configured to represent outdoor conditions or indoor conditions. In case of autonomous vehicles, the simulated environment may be configured to represent bumpy road surfaces, smooth road surfaces, traffic congestion and so on. More specifically, simulated agents in the simulated environment are configured to represent agents in real-world conditions in which the software-driven system is expected to operate.

At step 225, a behaviour of the software-driven system is evaluated by applying the identified test scenarios on a model of the software-driven system in the simulated environment. For example, the model is an analytical model of the software-driven system in machine-executable form. The model may be generated based on, for example, a digital twin of the software-driven system. In an embodiment, the behaviour of the software-driven system is evaluated by firstly, generating simulation instances based on the identified one or more test scenarios. Each of the simulation instances are generated by updating the simulated environment based on each of the identified test scenarios to simulate inputs to the software-driven system. The simulated inputs may include sensory inputs, human inputs and inputs from other systems. Further, each of the simulation instances are executed based on the model of the software-driven system to generate simulation results. The simulation instance may be executed using a simulation tool as stochastic simulations, deterministic simulations, dynamic simulations, continuous simulations, discrete simulations, local simulations, distributed simulations and so on. During execution of the simulation instances, the simulated inputs are applied to the model of the software-driven system. Based on the simulated inputs, the model generates a response. The simulation results are indicative of the response of the model to the simulated inputs. Further, the simulation results are analysed to determine the behaviour of the software-driven system in the one or more test scenarios. The response of the model is indicative of a behaviour of the software-driven system in the real-world scenario. Therefore, the response of the model is analysed to determine the behaviour of the software-driven system in the real-world scenario.

At step 230, the behaviour of the software-driven system in the real-world scenario is validated based on outcome of the evaluation. In an embodiment, validating the behaviour of the software-driven system comprises determining whether the behaviour of the software-driven system in the real-world scenario meets an expected standard. The expected standard may be associated with regulatory compliances, safety standards or predetermined specifications and so on. If the behaviour of the software-driven system meets the expected standard, an outcome of the validation is successful. Otherwise, the outcome of the validation is unsuccessful.

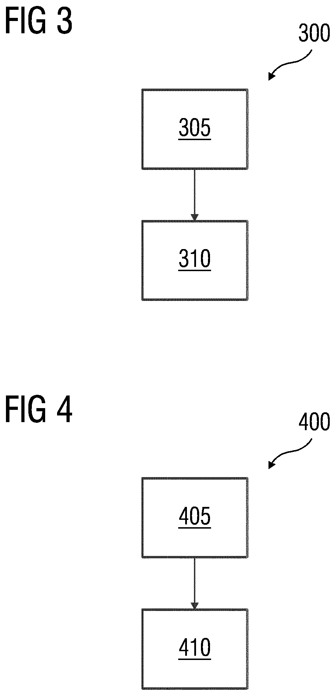

Each of the above steps are described in greater detail using FIGS 3 to 10.

FIG 3 is a flowchart depicting an exemplary method 300 of obtaining a plurality of test scenarios for testing of an autonomous vehicle, in accordance with an embodiment of the present invention. The method comprises steps 305 and 310.

At step 305, variable parameter definitions corresponding to variable parameters that are required for testing of the autonomous vehicle are obtained from the user device 110. For example, the testing may be associated with a braking functionality of the autonomous vehicle. The variable parameters affecting the braking functionality may include visibility ahead of the autonomous system, weather, and frictional coefficient between a tyre of the autonomous vehicle and the road. The variable parameter 'weather' may take include five values : '0' (for dry or sunny weather), '1' (for fog or cloudy weather), 2 (for light rain), 3 (for heavy rain) and 4 (for snow). The variable paramater 'frictional coefficient' may take five values: 0.9, 0.55, 0.4, 0.3 and 0.2. The variable parameter visibility may take five values: 1 (for normal visibility), 0.8 (for less visibility). It must be understood that the possible range of values may be specified as discrete levels, a continuous range. The variable parameter definitions may also be provided as probability distributions, for example, as shown below:

```
F1D1 ~ uniform(8, 30)
F1D2 ~ uniform(5, 30)
F2D1 ~ uniform(8, 30)
F2D2 ~ uniform(5, 30)
```

In addition to the variable parameter definitions, the testing personnel may also define the number of test scenarios that are required for testing of the autonomous vehicle. For example, the number of test scenarios required may be defined as 125. In another example, the number of test scenarios may be automatically derived based on the variable parameter definitions based on predefined rules.

At step 310, a design space corresponding to the variable parameters is generated. In the present example, the design space is associated with the variable parameters 'weather', 'visibility' and 'frictional coefficient'. The design may comprise both feasible test scenarios and infeasible test scenarios.

FIG 4 is a flowchart depicting an exemplary method 400 of generating real-world scenarios associated with the autonomous vehicle based on the set of variable parameters, in accordance with an embodiment of the present invention. The method comprises steps 405 and 410.

At step 405, one or more constraints associated with testing of the autonomous vehicle are obtained from a source. For example, the test scenarios may be provided by the testing personnel through the user device 110. In another embodiment, the constraints may be predefined. The constraints may be defined explicitly using, for example, a procedural language on the GUI of the user device 110 as shown below:

```
If(weather== 1):

frictional coefficient > 0.5 & visibility < 0.2

If( weather == 0):

frictional coefficient > 0.5 & visibility > 0.8

If( weather == 4):

frictional coefficient <= 0.2 & visibility = 0.5

If (weather == 3):

0.2  <= frictional coefficient < 0.4 & visibility = 0.6
```

In another example, if there are four variable parameters F1D1, F1D2, F2D1 and F2D2, the constraints may be of the form the constraints may be of the form:

$$F1D1 + F1D2 < 32,$$

$$F1D1 + F1D2 < 23$$

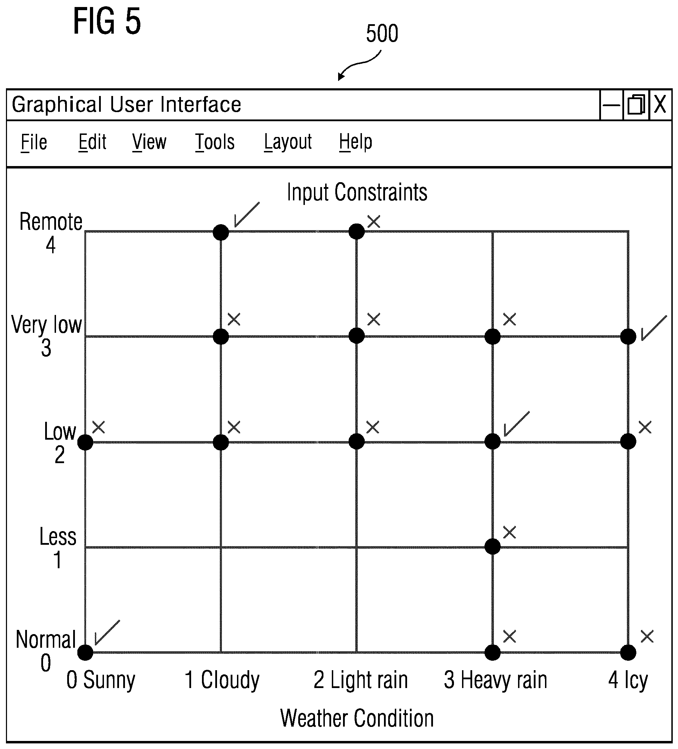

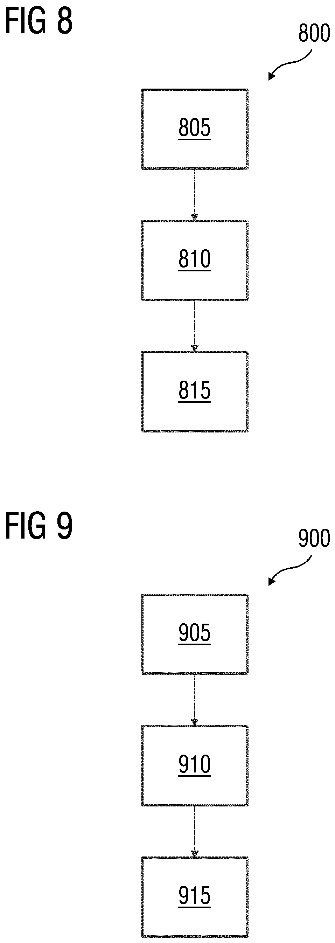

In another implementation, the constraints are provided graphically. For example, the testing personnel may provide the constraints by drawing a boundary in a two-dimensional view of the design space on a Graphical User Interface of the user device 110. In another example, the testing personnel may not give any constraints. A two-dimensional view of the design space is shown to the testing personnel on a GUI 500 of the user device as illustrated in FIG 5. Further, a set of random samples in the design space may be highlighted as indicated by the dots. Further, the testing personnel is provided an option to select feasible test scenarios and reject infeasible test scenarios, for example, by selecting an 'accept' or 'reject' option next to each of the dots. Accordingly, the test personnel may accept or reject the random samples. In the GUI 500, the samples that are ticked indicate the feasible test scenarios, whereas the samples that are crossed indicate the infeasible test scenarios. Based on the accepted samples, the apparatus 105 may automatically determine the constraints as explained using FIG 9.

At step 410, dependency between the variable parameters is determined. If dependency exists among the variable parameters, method 415 is performed. If no dependency exists between the variables, a space filling algorithm is used to generate test scenarios from the design space corresponding to the variable parameters as shown in step 420. The space filling algorithm may include any sampling algorithm that may perform sampling in the design space. Each of the samples generated by the space filling algorithm corresponds to a test scenario. The samples generated may include random samples or optimal samples depending on a type of the space filling algorithm. The space filling algorithm may generate the optimal samples based on known coverage metrics such as inter-sample force, maximin, minimax or entropy criterion. The coverage metrics ensure that the samples generated from the design space are well-spaced.

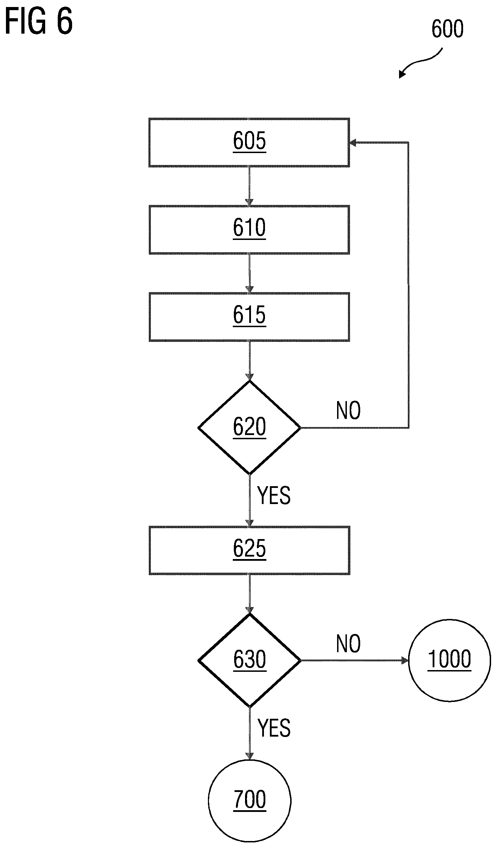

FIG 6 is a flowchart depicting an exemplary method 600 of identifying test scenarios suitable for testing the autonomous vehicle based on the at least one real-world scenario using a trained machine learning model, in accordance with an embodiment of the present invention. More specifically, the present embodiment relates to identification of the one or more test scenarios when the constraints are explicitly provided by a testing personnel. Here, the design space is sampled using a machine learning algorithm to generate N number of required samples. For example, N may be specified as '125' by the testing personnel.

At step 605, k-means clustering is applied to the design space to generate k clusters. Further, kxN random samples are generated from the k clusters.

At step 610, the constraints are applied to the design space to determine an infeasible design space. The infeasible design space corresponds to design points or test scenarios that are not suitable for testing of the autonomous vehicle. The remaining design points in the design space correspond to test scenarios that are suitable for testing of the autonomous vehicle. At step 615, the kxN random samples that are within the feasible design space are clustered to form N clusters using K-means clustering. Further, centroids of the N-clusters are calculated.

At step 620, each of the centroids of the N-clusters are checked to determine whether any of the centroid falls in the infeasible design space. If no, step 625 is performed. Otherwise, step 605 is repeated until a predefined termination criterion is met.

At step 625, the centroids of the N-clusters are generated as samples or feasible test scenarios for testing of the autonomous vehicle. The feasible test scenarios generated here form a first set of test scenarios.

At step 630, it is determined whether the first set of test scenarios is suitable for testing the autonomous vehicle. In an embodiment, the suitability of the first set of test scenarios is based on the number of feasible test scenarios present within the first set of test scenarios. If the number of feasible test scenarios is less than the required number of test scenarios, method 700 is performed to generate more feasible test scenarios. Otherwise, method 1000 is performed.

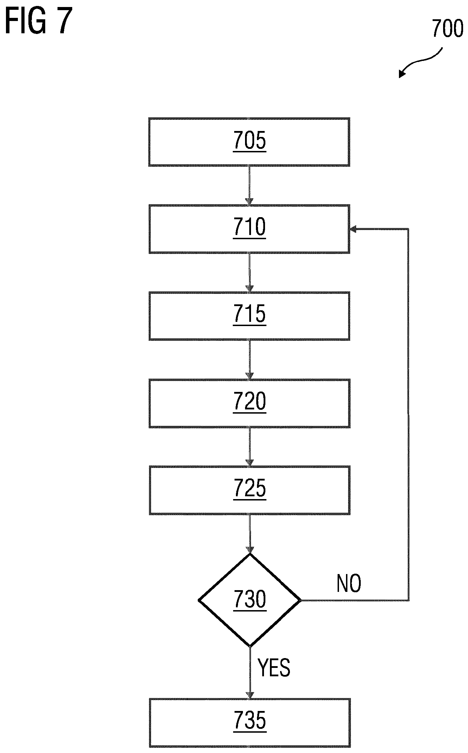

FIG 7 is a flowchart depicting an exemplary method 700 of generating test scenarios suitable for testing of the autonomous vehicle based on an optimization criterion, in accordance with an embodiment of the present invention. At step 705, Np random samples are generated from the design space using a Latin Hypercube Design (LHD) of the variables. At step 710, a cost criterion associated with each of the Np samples is calculated. In the present embodiment, the cost criterion is based on intra-sample repulsive force corresponding to each of the samples. More specifically, the cost criterion is a summation of the intra-sample repulsive force for each sample. The intra-sample repulsive force is a measure of an entropy, that is a degree of randomness, associated with the sample. In another embodiment, the cost criterion is an intra-sample distance, that is a distance between the sample and another sample.

At step 715, a predefined number of samples are selected from the Np samples based on predefined criteria corresponding to the cost criterion. For example, the predefined number of samples may be $N_p/2$ and the predefined criteria may be such the selected $N_p/2$ samples have low value of the summation of the intra-sample repulsive forces compared to any of the remaining $N_p/2$ samples. At step 720, the selected samples are optimised using an optimisation function. In a preferred embodiment, the optimisation function performs optimisation using an evolutionary algorithm such as, but not limited to, genetic algorithm. More specifically, the selected samples serve as initial values for performing the optimization. The genetic algorithm may perform a constrained optimisation of the selected samples based on the one or more constraints associated with the variable parameters.

At step 725, the optimisation function generates a new set of optimal samples from the selected samples. At step 730, at least one termination criterion associated with the optimisation is checked. The termination criterion may be for example, checking whether the number of optimal samples generated is greater than or equal to the number of samples required. If the termination criterion is satisfied, test scenarios corresponding to the optimal samples are determined in step 735. Otherwise, steps 710 to 730 are repeated until the termination criterion is satisfied.

FIG 8 is a flowchart depicting an exemplary method 800 for determining test scenarios that are suitable for testing of the autonomous vehicle, in accordance with another embodiment of the present invention. In the present embodiment, constraints are defined graphically.

At step 805, a graphical representation of the design space is provided to the testing personnel on a Graphical User Interface.

At step 810, the testing personnel graphically demarcate feasible test scenarios and infeasible test scenarios in the design space. For example, the testing personnel may create a sketch of a feasible region in the design space. The feasible region includes feasible test scenarios that are suitable for testing the autonomous vehicle. Alternatively, the testing personnel may define an infeasible region comprising infeasible test scenarios that are unsuitable for testing the autonomous vehicle.

At step 815, a machine learning algorithm is used to generate a parametric sketch of the feasible region in the design space. The parametric sketch of the feasible region is further used to generate the pruned design space. Further, feasible test scenarios are generated from the pruned design space using the method 600.

FIG 9 is a flowchart depicting an exemplary method 900 for identifying test scenarios suitable for testing the autonomous vehicle, in accordance with yet another embodiment of the present invention. In the present embodiment, no constraints are provided by the testing personnel.

At step 905, random test scenarios are generated by means of random sampling of the design space using a space filling algorithm as explained earlier.

At step 910, the testing personnel is provided an option to accept feasible test scenarios and reject infeasible test scenarios.

At step 915, a machine learning algorithm is used to determine a pattern corresponding to acceptance of feasible test scenarios by the testing personnel. The pattern may be determined using convex-hull approach. The convex-hull approach may be for example, Graham's algorithm that creates a boundary of the feasible design space paths based on the feasible test scenarios accepted by the testing personnel. Further, method 600 is performed.

Upon identifying the test scenarios, the evaluation module 180 generates a simulated environment representing the real-world scenario in which the autonomous vehicle is to be tested. In the present example of the autonomous vehicle, the simulated environment representing driving conditions in the real-world is generated based on each of the test scenarios identified. As the autonomous vehicle is being tested for verifying the braking functionality, simulated agents corresponding to weather, visibility and frictional coefficient are configured. The simulated agents are configured based on physics-based models.

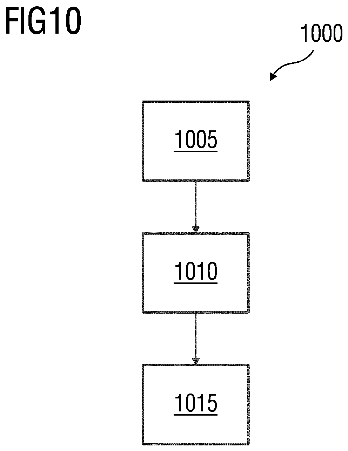

FIG 10 is a flowchart depicting an exemplary method 1000 for evaluating the behaviour of the autonomous vehicle, in accordance with an embodiment of the present invention.

At step 1005, simulation instances for testing the autonomous vehicle based on the identified test scenarios are generated. The simulation instance is generated by updating the simulated environment based on the identified test scenarios to simulate inputs to the autonomous vehicle. More specifically, the simulated inputs represent sensory inputs corresponding to weather, visibility and the frictional coefficient. As a result, a simulation instance is generated corresponding to each of the identified test scenarios.

At step 1010, the simulation instances are executed based on the model of the autonomous vehicle to generate simulation results. The model of the autonomous vehicle is configured to represent operating characteristics of the autonomous vehicle. During execution of the simulation instances, the simulated inputs are provided as inputs to the model in order to generate responses from the model. The model may correspond to a braking function associated with the autonomous vehicle.

At step 1015, the responses from the model are further analysed to determine the behaviour of the autonomous vehicle in the identified test scenarios. In the present example, the behaviour of the autonomous system may correspond to a stopping distance associated with the autonomous vehicle, when brakes are applied in a given test scenario. The stopping distance is the sum of a reaction distance and a braking distance. For example, the output of the model may indicate both the reaction distance and the braking distance in microseconds.

The validation module 185 validates the behaviour of the autonomous vehicle based on expected standards. For example, as per the expected standards the stopping distance should not exceed 50 meters when an autonomous vehicle is operating at 50 kmpH. Similarly, standards may be defined based on different conditions. If the stopping distance exceeds the values defined by the standards in any of the test scenarios, the validation of the autonomous vehicle is not successful. Otherwise, the autonomous vehicle is successfully validated. The report generation module 190 may further generate a report indicating the outcome of validation. In an implementation, the report may indicate the test scenarios used and outcome of evaluation corresponding to each of the test scenarios. The generated report may be further transmitted to the user device 110, to be displayed on a Graphical User Interface associated with the user device 110.

The present invention provides accurate and more reliable validation results compared to prior art by eliminating all unrealistic test scenarios from the design space. Further, the present invention also eliminates human efforts required in identifying feasible test scenarios, thereby enabling faster validation of software-driven systems.

The present invention may take the form of a computer program product comprising program modules accessible from computer-usable or computer-readable medium storing program code for use by or in connection with one or more computers, processors, or instruction execution system. For the purpose of this description, a computer-usable or computer-readable medium is any apparatus that may contain, store, communicate, propagate, or transport the program for use by or in connection with the instruction execution system, apparatus, or device. The medium may be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processors and program code for implementing each aspect of the technology may be centralized or distributed (or a combination thereof) as known to those skilled in the art.

While the invention has been illustrated and described in detail with the help of a preferred embodiment, the invention is not limited to the disclosed examples. Other variations can be deducted by those skilled in the art without leaving the scope of protection of the claimed invention.

Reference list

| 100 | environment of an apparatus for validating a software-driven system |
|---|---|
| 105 | apparatus for validating a software-driven system |
| 110 | user device |
| 115 | network |
| 120 | processing unit |
| 125 | memory |
| 130 | storage unit |
| 135 | communication unit |
| 140 | network interface |
| 145 | input unit |
| 150 | output unit |
| 155 | standard interface or bus |
| 160 | testing module |
| 165 | preprocessing module |
| 170 | scenario identification module |
| 175 | test case generation module |
| 180 | evaluation module |
| 185 | validation module |
| 190 | report generation module |
| 195 | database |

**Claims**

1. A computer-implemented method for validating a software-driven system based on real-world scenarios in a Computer-Aided Engineering environment, the method comprising:

obtaining (S205), by a processing unit (120) and from a source, a plurality of test scenarios that correspond to testing of the software-driven system, in the form of variable parameter definitions, wherein the source is one of an input device, a user device or a database and wherein the variable parameters include at least one of attributes and process parameters associated with the software-driven system;

generating a design space comprising a plurality of test scenarios based on the variable parameter definitions, wherein the design space refers to a multidimensional combination and interaction of the variable parameters, wherein the design space encompasses possible combinations of the variable parameters and each of the combinations of the variable parameters correspond to a test scenario or a design point, wherein the design space comprises both feasible test scenarios suitable for testing the software-driven system and infeasible scenarios not suited for testing the software-driven system;

generating (S210) at least one real-world scenario associated with the software-driven system based on a set of the variable parameters, this step comprising determining one or more constraints associated with the variable parameters and applying the determined one or more constraints to the design space to generate a pruned design corresponding to the at least one real-world scenario;

identifying (S215) one or more feasible test scenarios for testing the software-driven system based on the at least one real-world scenario from the plurality of test scenarios by sampling the pruned design space using a trained machine learning model, wherein the pruned design space is sampled using the machine learning algorithm to generate N number of required samples and wherein the step of identifying (s215) further comprises the steps of:

applying (s605) k-means clustering to the design space to generate k clusters and generating kxN random samples from the k clusters;

applying (s610) the constraints to the design space to determine an infeasible design space, wherein the infeasible design space corresponds to design points or test scenarios that are not suitable for testing of the autonomous vehicle, wherein the remaining design points in the design space correspond to test scenarios that are suitable for testing the software-driven system;

clustering (S615) the kxN random samples that are within the feasible design space to form N clusters using k-means clustering and calculating centroids of the N-clusters;

checking (s620) each of the centroids of the N-clusters to determine whether any of the centroid falls in the infeasible design space;

if no centroids falls in the infeasible design space, generating (s625) the centroids of the N-clusters as samples of feasible test scenarios for testing of the software-driven system, otherwise, repeating the step of applying (s605) k-means clustering to the design space to generate k clusters and generating kxN random samples from the k clusters until a predefined termination criterion is met;

determining (s630) whether the first set of test scenarios is suitable for testing the software-driven system is based on the number of feasible test scenarios present within the first set of test scenarios;

generating (S220) a simulated environment representing the real-world scenario in which the software-driven system is to be tested, using a simulation tool in the Computer-Aided Engineering Environment, wherein simulated agents in the simulated environment are physics-based models associated with objects in a physical environment associated with the software driven system which are used to simulate sensory inputs to the software driven system and are configured to represent real-world conditions in which the software-driven system is expected to operate;

evaluating (S225) a behaviour of the software-driven system by applying the identified test scenarios on a model of the software-driven system in the simulated environment; and

validating (S230) the behaviour of the software-driven system in the real-world scenario based on outcome of the evaluation.

2. The method according to claim 1, further comprising:
generating the model of the software-driven system in the Computer-Aided Engineering environment.

3. The method according to claims 1 and 2, wherein identifying the one or more feasible test scenarios which are suitable for testing the software-driven system comprises:

generating samples from the pruned design space, by feeding an input corresponding to the pruned design space to the trained machine learning model; and

determining the one or more feasible test scenarios based on the generated samples, wherein each of the samples comprise values of the variable parameters to be used in a specific test scenario.

4. The method according to claim 3, further comprising:

generating optimal samples from the pruned design space based on at least one optimization criterion; and

determining the one or more feasible test scenarios based on the generated optimal samples.

5. The method according to any of the preceding claims, wherein evaluating the behaviour of the software-driven system by applying the identified test scenarios on the model of the software-driven system in the simulated environment comprises:

generating simulation instances for testing the software-driven system based on the identified one or more test scenarios;

executing the simulation instances based on the model of the software-driven system to generate simulation results; and

analysing the simulation results to determine the behaviour of the software-driven system in the real-world scenario.

6. The method according to any of the preceding claims, wherein validating the behaviour of the software-driven system in the real-world scenario based on the outcome of the evaluation comprises:

determining whether the behaviour of the software-driven system in the real-world scenario meets an expected standard.

7. The method according to any of the preceding claims, further comprising:
generating a notification indicating an outcome of the validation on a Graphical User Interface.

8. An apparatus (105) for testing a software-driven system, the apparatus (105) comprising:

one or more processing units (120); and

a memory unit (125) communicatively coupled to the one or more processing units (120), wherein the memory unit (125) comprises a testing module (160) stored in the form of machine-readable instructions executable by the one or more processing units (120), wherein the testing module (160) is configured to perform method steps according to any of the claims 1 to 7.

9. A cloud-computing system (100) comprising:

   one or more user devices (110); and
   an apparatus (105) according to claim 8 communicatively coupled to the one or more user devices (110) configured to validate a software-driven system according to any of the method claims 1 to 7.

10. A computer-program product having machine-readable instructions stored therein, which when executed by one or more processing units (120), cause the processing units (120) to perform a method according to any of the claims 1 to 7.

11. A computer-readable storage medium comprising instructions which, when executed by one or more processing units (120), cause the one or more processing units (120) to perform a method according to any of the claims 1 to 7.

**Patentansprüche**

1. Computerimplementiertes Verfahren zum Validieren eines softwaregesteuerten Systems basierend auf realen Szenarien in einer Computer-Aided Engineering-Umgebung, wobei das Verfahren Folgendes umfasst:

   Erhalten (S205) einer Mehrzahl von dem Testen des softwaregesteuerten Systems entsprechenden Testszenarien in Form von Definitionen variabler Parameter durch eine Verarbeitungseinheit (120) und von einer Quelle, wobei die Quelle eine von einer Eingabevorrichtung, einer Benutzervorrichtung oder einer Datenbank ist und wobei die variablen Parameter Attribute und/oder Prozessparameter beinhalten, die mit dem softwaregesteuerten System assoziiert sind;
   Erzeugen eines Entwurfsraums, der eine Mehrzahl von Testszenarien umfasst, basierend auf den Definitionen variabler Parameter, wobei sich der Entwurfsraum auf eine mehrdimensionale Kombination und Interaktion der variablen Parameter bezieht, wobei der Entwurfsraum mögliche Kombinationen der variablen Parameter umfasst und jede der Kombinationen der variablen Parameter einem Testszenario oder einem Entwurfspunkt entspricht, wobei der Entwurfsraum sowohl realisierbare Testszenarien, die zum Testen des softwaregesteuerten Systems geeignet sind, als auch unrealisierbare Szenarien umfasst, die zum Testen des softwaregesteuerten Systems nicht geeignet sind;
   Erzeugen (S210) mindestens eines realen Szenarios, das mit dem softwaregesteuerten System assoziiert ist, basierend auf einem Satz der variablen Parameter, wobei dieser Schritt Bestimmen einer oder mehrerer Einschränkungen, die mit den variablen Parametern assoziiert sind, und Anwenden der einen oder mehreren der bestimmten Einschränkungen auf den Entwurfsraum umfasst, um einen beschnittenen Entwurf zu erzeugen, der dem mindestens einen realen Szenario entspricht;
   Identifizieren (S215) eines oder mehrerer realisierbarer Testszenarien zum Testen des softwaregesteuerten Systems basierend auf dem mindestens einen realen Szenario aus der Mehrzahl von Testszenarien durch Abtasten des beschnittenen Entwurfsraums unter Verwendung eines trainierten Modells für maschinelles Lernen, wobei der beschnittene Entwurfsraum unter Verwendung des Algorithmus für maschinelles Lernen abgetastet wird, um eine Anzahl N erforderlicher Stichproben zu erzeugen, und wobei der Schritt des Identifizierens (s215) ferner die folgenden Schritte umfasst:

      Anwenden (s605) von k-Means-Clustering auf den Entwurfsraum, um k Cluster zu erzeugen und k x N Zufallsstichproben aus den k Clustern zu erzeugen;
      Anwenden (s610) der Einschränkungen auf den Entwurfsraum, um einen unrealisierbaren Entwurfsraum zu bestimmen, wobei der unrealisierbare Entwurfsraum Entwurfspunkten oder Testszenarien entspricht, die nicht zum Testen des autonomen Fahrzeugs geeignet sind, wobei die verbleibenden Entwurfspunkte in dem Entwurfsraum Testszenarien entsprechen, die zum Testen des softwaregesteuerten Systems geeignet sind;
      Clustern (S615) der k x N Zufallsstichproben, die sich innerhalb des realisierbaren Entwurfsraums befinden, um N Cluster unter Verwendung von k-Means-Clustering zu bilden, und Berechnen von Schwerpunkten der N Cluster;
      Prüfen (s620) jedes der Schwerpunkte der N Cluster, um zu bestimmen, ob einer der Schwerpunkte in den unrealisierbaren Entwurfsraum fällt;
      falls keine Schwerpunkte in den unrealisierbaren Entwurfsraum fallen, Erzeugen (s625) der Schwerpunkte der N Cluster als Stichproben realisierbarer Testszenarien zum Testen des softwaregesteuerten Systems, andernfalls Wiederholen des Schritts des Anwendens (s605) von k-Means-Clustering auf den Entwurfsraum, um k Cluster zu erzeugen, und Erzeugen von k x N Zufallsstichproben aus den k Clustern, bis ein vordefiniertes Beendigungskriterium erfüllt ist;
Bestimmen (s630), ob der erste Satz von Testszenarien zum Testen des softwaregesteuerten Systems geeignet ist, basierend auf der Anzahl von realisierbaren Testszenarien, die innerhalb des ersten Satzes von Testszenarien vorhanden sind;
Erzeugen (S220) einer simulierten Umgebung, die das reale Szenario darstellt, in dem das softwaregesteuerte System getestet werden soll, unter Verwendung eines Simulationswerkzeugs in der Computer-Aided Engineering-Umgebung, wobei simulierte Agenten in der simulierten Umgebung physikbasierte Modelle sind, die mit Objekten in einer physischen Umgebung assoziiert sind, die mit dem softwaregesteuerten System assoziiert sind und die verwendet werden, um sensorische Eingaben in das softwaregesteuerte System zu simulieren, und dazu ausgelegt sind, reale Bedingungen darzustellen, unter denen das softwaregesteuerte System voraussichtlich betrieben wird;
Bewerten (S225) eines Verhaltens des softwaregesteuerten Systems durch Anwenden der identifizierten Testszenarien auf ein Modell des softwaregesteuerten Systems in der simulierten Umgebung; und Validieren (S230) des Verhaltens des softwaregesteuerten Systems im realen Szenario basierend auf dem Ergebnis der Bewertung.

2. Verfahren nach Anspruch 1, ferner umfassend:
Erzeugen des Modells des softwaregesteuerten Systems in der Computer-Aided Engineering-Umgebung.

3. Verfahren nach Anspruch 1 und 2, wobei das Identifizieren des einen oder der mehreren realisierbaren Testszenarien, die zum Testen des softwaregesteuerten Systems geeignet sind, Folgendes umfasst:

Erzeugen von Stichproben aus dem beschnittenen Entwurfsraum, indem dem trainierten Modell für maschinelles Lernen eine Eingabe zugeführt wird, die dem beschnittenen Entwurfsraum entspricht; und
Bestimmen des einen oder der mehreren realisierbaren Testszenarien basierend auf den erzeugten Stichproben, wobei jede der Stichproben Werte der variablen Parameter umfasst, die in einem spezifischen Testszenario verwendet werden sollen.

4. Verfahren nach Anspruch 3, ferner umfassend:

Erzeugen optimaler Stichproben aus dem beschnittenen Entwurfsraum basierend auf mindestens einem Optimierungskriterium; und
Bestimmen des einen oder der mehreren realisierbaren Testszenarien basierend auf den erzeugten optimalen Stichproben.

5. Verfahren nach einem der vorhergehenden Ansprüche, wobei das Bewerten des Verhaltens des softwaregesteuerten Systems durch Anwenden der identifizierten Testszenarien auf das Modell des softwaregesteuerten Systems in der simulierten Umgebung Folgendes umfasst:

Erzeugen von Simulationsinstanzen zum Testen des softwaregesteuerten Systems basierend auf dem einen oder den mehreren identifizierten Testszenarien;
Ausführen der Simulationsinstanzen basierend auf dem Modell des softwaregesteuerten Systems, um Simulationsergebnisse zu erzeugen; und
Analysieren der Simulationsergebnisse, um das Verhalten des softwaregesteuerten Systems im realen Szenario zu bestimmen.

6. Verfahren nach einem der vorhergehenden Ansprüche, wobei das Validieren des Verhaltens des softwaregesteuerten Systems in dem realen Szenario basierend auf dem Ergebnis der Bewertung Folgendes umfasst:
Bestimmen, ob das Verhalten des softwaregesteuerten Systems im realen Szenario einem erwarteten Standard entspricht.

7. Verfahren nach einem der vorhergehenden Ansprüche, ferner umfassend:
Erzeugen einer Benachrichtigung, die ein Ergebnis der Validierung auf einer grafischen Benutzeroberfläche angibt.

8. Einrichtung (105) zum Testen eines softwaregesteuerten Systems, wobei die Einrichtung (105) Folgendes umfasst:

eine oder mehrere Verarbeitungseinheiten (120); und
eine Speichereinheit (125), die kommunikativ mit der einen oder den mehreren Verarbeitungseinheiten (120) gekoppelt ist, wobei die Speichereinheit (125) ein Testmodul (160) umfasst, das in Form von maschinenlesbaren Anweisungen gespeichert ist, die von der einen oder den mehreren Verarbeitungseinheiten (120) ausgeführt werden können, wobei das Testmodul (160) dazu ausgelegt ist, die Verfahrensschritte nach einem der Ansprüche 1 bis 7 auszuführen.

9. Cloud-Computing-System (100), umfassend:

eine oder mehrere Benutzervorrichtungen (110); und
eine Einrichtung (105) nach Anspruch 8, die kommunikativ mit der einen oder den mehreren Benutzervorrichtungen (110) gekoppelt und dazu ausgelegt ist, ein softwaregesteuertes System nach einem der Verfahrensansprüche 1 bis 7 zu validieren.

10. Computerprogrammprodukt mit darin gespeicherten maschinenlesbaren Anweisungen, die bei Ausführung durch eine oder mehrere Verarbeitungseinheiten (120) die Verarbeitungseinheiten (120) veranlassen, ein Verfahren nach einem der Ansprüche 1 bis 7 durchzuführen.

11. Computerlesbares Speichermedium, umfassend Anweisungen, die bei Ausführung durch eine oder mehrere Verarbeitungseinheiten (120) die eine oder die mehreren Verarbeitungseinheiten (120) veranlassen, ein Verfahren nach einem der Ansprüche 1 bis 7 durchzuführen.

## Revendications

1. Procédé mis en œuvre par ordinateur pour valider un système piloté par logiciel d'après des scénarios du monde réel dans un environnement d'ingénierie assistée par ordinateur, le procédé comprenant :

l'obtention (S205), par une unité (120) de traitement et à partir d'une source, d'une pluralité de scénarios de tests qui correspondent à un test du système piloté par logiciel, sous forme de définitions de paramètres variables, la source étant un dispositif d'entrée, un dispositif d'utilisateur ou une base de données et les paramètres variables incluant des attributs et/ou des paramètres de processus associés au système piloté par logiciel ;
la génération d'un espace de conception comprenant une pluralité de scénarios de test d'après les définitions de paramètres variables, l'espace de conception désignant une combinaison multidimensionnelle et une interaction des paramètres variables, l'espace de conception englobant des combinaisons possibles des paramètres variables et chacune des combinaisons des paramètres variables correspondant à un scénario de test ou à un point de conception, l'espace de conception comprenant à la fois des scénarios de test faisables et appropriés pour tester le système piloté par logiciel et des scénarios infaisables non appropriés pour tester le système piloté par logiciel ;
la génération (S210) d'au moins un scénario du monde réel associé au système piloté par logiciel d'après un ensemble des paramètres variables, cette étape comprenant la détermination d'une ou plusieurs contraintes associées aux paramètres variables et l'application de la ou des contraintes déterminées à l'espace de conception pour générer une conception élaguée correspondant au(x) scénario(s) du monde réel ;
l'identification (S215) d'un ou de plusieurs scénarios de test faisables pour tester le système piloté par logiciel sur la base du ou des scénarios du monde réel parmi la pluralité de scénarios de test en échantillonnant l'espace de conception élagué à l'aide d'un modèle d'apprentissage automatique entraîné, l'espace de conception élagué étant échantillonné à l'aide de l'algorithme d'apprentissage automatique pour générer un nombre N d'échantillons requis et l'étape d'identification (s215) comprenant en outre les étapes de :

application (s605) d'un regroupement par k moyennes à l'espace de conception pour générer k groupes et génération de kxN échantillons aléatoires à partir des k groupes ;
application (s610) des contraintes à l'espace de conception pour déterminer un espace de conception infaisable, l'espace de conception infaisable correspondant à des points de conception ou à des scénarios de test non appropriés pour tester le véhicule autonome, les points de conception restants dans l'espace de conception correspondant à des scénarios de test appropriés pour tester le système piloté par logiciel ;
regroupement (S615) des kxN échantillons aléatoires qui se trouvent dans l'espace de conception faisable pour former N groupes en utilisant le regroupement par k moyennes, et calcul des centroïdes des N groupes ;
vérification (s620) de chacun des centroïdes des N groupes pour déterminer si l'un quelconque des centroïdes tombe dans l'espace de conception infaisable ;
si aucun centroïde ne tombe dans l'espace de conception infaisable, génération (s625) des centroïdes des N groupes en tant qu'échantillons de scénarios de test faisables pour tester le système piloté par logiciel, sinon répétition de l'étape d'application (s605) du regroupement par k moyennes à l'espace de conception pour générer k groupes et génération de kxN échantillons aléatoires à partir des k groupes jusqu'à ce qu'un critère d'arrêt prédéfini soit satisfait ;

la détermination (s630) de l'adéquation ou de l'inadéquation du premier ensemble de scénarios de test pour tester le système piloté par logiciel étant basée sur le nombre de scénarios de test faisables présents dans le premier ensemble de scénarios de test ;

génération (S220) d'un environnement simulé représentant le scénario du monde réel dans lequel le système piloté par logiciel doit être testé, à l'aide d'un outil de simulation dans l'environnement d'ingénierie assistée par ordinateur, des agents simulés dans l'environnement simulé étant des modèles basés sur la physique associés à des objets dans un environnement physique associé au système piloté par logiciel qui sont utilisés pour simuler des entrées sensorielles dans le système piloté par logiciel et sont configurés pour représenter des conditions du monde réel dans lesquelles il est prévu que le système piloté par logiciel fonctionne ;

évaluation (S225) d'un comportement du système piloté par logiciel en appliquant les scénarios de test identifiés sur un modèle du système piloté par logiciel dans l'environnement simulé ; et

validation (S230) du comportement du système piloté par logiciel dans le scénario du monde réel en fonction des résultats de l'évaluation.

2. Procédé selon la revendication 1, comprenant en outre :
la génération du modèle du système piloté par logiciel dans l'environnement d'ingénierie assistée par ordinateur.

3. Procédé selon les revendications 1 et 2, l'identification du ou des scénarios de test faisables qui sont appropriés pour tester le système piloté par logiciel comprenant :

la génération d'échantillons à partir de l'espace de conception élagué, en introduisant dans le modèle d'apprentissage automatique entraîné une entrée correspondant à l'espace de conception élagué ; et
la détermination du ou des scénarios de test faisables d'après les échantillons générés, chacun des échantillons comprenant des valeurs des paramètres variables à utiliser dans un scénario de test spécifique.

4. Procédé selon la revendication 3, comprenant en outre :

la génération d'échantillons optimaux à partir de l'espace de conception élagué sur la base d'au moins un critère d'optimisation ; et
la détermination du ou des scénarios de test faisables sur la base des échantillons optimaux générés.

5. Procédé selon l'une quelconque des revendications précédentes, l'évaluation du comportement du système piloté par logiciel en appliquant les scénarios de test identifiés sur le modèle du système piloté par logiciel dans l'environnement simulé comprenant :

la génération d'instances de simulation pour tester le système piloté par logiciel sur la base du ou des scénarios de test identifiés ;
l'exécution des instances de simulation sur la base du modèle du système piloté par logiciel pour générer des résultats de simulation ; et
l'analyse des résultats de la simulation pour déterminer le comportement du système piloté par logiciel dans le scénario du monde réel.

6. Procédé selon l'une quelconque des revendications précédentes, la validation du comportement du système piloté par logiciel dans le scénario du monde réel sur la base du résultat de l'évaluation comprenant :
le fait de déterminer si le comportement du système piloté par logiciel dans le scénario du monde réel répond à une norme attendue.

7. Procédé selon l'une quelconque des revendications précédentes, comprenant en outre :
la génération d'une notification indiquant un résultat de la validation sur une interface graphique d'utilisateur.

8. Appareil (105) destiné à tester un système piloté par logiciel, l'appareil (105) comprenant :

une ou plusieurs unités (120) de traitement ; et

une unité (125) de mémoire couplée en communication à l'unité ou aux unités (120) de traitement, l'unité (125) de mémoire comportant un module (160) de test stocké sous la forme d'instructions lisibles par machine exécutables par l'unité ou les unités (120) de traitement, le module (160) de test étant configuré pour réaliser les étapes de procédé selon l'une quelconque des revendications 1 à 7.

9. Système (100) d'informatique en nuage comprenant :

un ou plusieurs dispositifs (110) d'utilisateurs ; et
un appareil (105) selon la revendication 8, couplé en communication au(x) dispositif (s) (110) d'utilisateur(s), configuré pour valider un système piloté par logiciel selon l'une quelconque des revendications de procédé 1 à 7.

10. Produit-programme informatique dans lequel sont stockées des instructions lisibles par machine, qui lorsqu'elles sont exécutées par une ou plusieurs unités (120) de traitement, amènent les unités (120) de traitement à réaliser un procédé selon l'une quelconque des revendications 1 à 7.

11. Support de stockage lisible par ordinateur comprenant des instructions qui, lorsqu'elles sont exécutées par une ou plusieurs unités (120) de traitement, amènent l'unité ou les unités (120) de traitement à réaliser un procédé selon l'une quelconque des revendications 1 à 7.

FIG 1A

100

105

115

110

# FIG 1B

FIG 2

200

FIG 3

300

305

310

FIG 4

400

405

410

# FIG 5

500

# FIG 6

600

# FIG 7

700

```
┌─────────────────┐
│       705       │
└─────────────────┘
         │
         ▼
┌─────────────────┐
│       710       │◄──────┐
└─────────────────┘       │
         │                │
         ▼                │
┌─────────────────┐       │
│       715       │       │
└─────────────────┘       │
         │                │
         ▼                │
┌─────────────────┐       │
│       720       │       │
└─────────────────┘       │
         │                │
         ▼                │
┌─────────────────┐       │
│       725       │       │
└─────────────────┘       │
         │                │
         ▼                │
        ╱╲          NO    │
       ╱  ╲ ───────────────┘
      ╱ 730╲
      ╲    ╱
       ╲  ╱
        ╲╱
         │
        YES
         │
         ▼
┌─────────────────┐
│       735       │
└─────────────────┘
```

## FIG 8

800

805

810

815

## FIG 9

900

905

910

915

FIG10

1000

1005

1010

1015

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9811074 B1

- WO 2019234726 A1